Europäisches Patentamt

European Patent Office

Office européen des brevets

(19)

(11) Publication number: **0 022 601**
**B1**

(12) **EUROPEAN PATENT SPECIFICATION**

(45) Date of publication of patent specification: **06.04.83**

(51) Int. Cl.³: **H 03 B 9/14**

(21) Application number: **80200676.7**

(22) Date of filing: **10.07.80**

(54) **Trapatt oscillator.**

(30) Priority: **16.07.79 GB 7924638**

(43) Date of publication of application:
**21.01.81 Bulletin 81/3**

(45) Publication of the grant of the patent:
**06.04.83 Bulletin 83/14**

(84) Designated Contracting States:
**DE FR GB IT NL SE**

(56) References cited:
**DE - B - 2 114 918**
**GB - A - 2 026 800**
**US - A - 3 646 357**
**US - A - 3 714 605**
**US - A - 3 721 919**
**US - A - 3 743 966**
**US - A - 3 842 370**
**US - A - 3 919 667**

**PROC. IEE, Vol. 122, No. 11, November 1975 S. C. CRIPPS et al. "Double-Diode Trapatt Pulse Generator with Applications to Avalanche-Diode Research" pages 1187 to 1192**

(73) Proprietor: **PHILIPS ELECTRONIC AND ASSOCIATED INDUSTRIES LIMITED**
**Abacus House 33 Gutter Lane**
**London EC2V 8AH (GB)**

(84) **GB**

(73) Proprietor: **N.V. Philips' Gloeilampenfabrieken**
**Groenewoudseweg 1**
**NL-5621 BA Eindhoven (NL)**

(84) **DE FR IT NL SE**

(72) Inventor: **Davies, Robert**
**Philips Research Laboratories**
**Redhill Surrey RH1 5HA (GB)**
Inventor: **Newton, Barrie Hulme**
**Philips Research Laboratories**
**Redhill Surrey RH1 5HA (GB)**
Inventor: **Booth, Peter Leslie**
**Philips Research Laboratories**
**Redhill Surrey RH1 5HA (GB)**

(74) Representative: **Boxall, Robin John et al,**
**Philips Electronic and Associated Ind. Ltd. Patent Department Mullard House Torrington Place London WC1E 7HD (GB)**

Courier Press, Leamington Spa, England.

Trapatt oscillator

This invention relates to a time-delay-triggered Trapatt oscillator comprising a Trapatt diode and a transmission line connected across the diode, wherein the transmission line comprises a trigger element in the form of a step transition from a high to a low impedance as seen from the diode, the transition being spaced from the diode to reflect energy produced by the diode back thereto so as to trigger the further production of energy by the diode, and wherein the transmission line comprises further transitions in impedance spaced along the line.

A typical such Trapatt oscillator in coaxial line is described in U.S. Patent No. 3,842,370. In this oscillator, the majority of the transmission line is of a uniform impedance which is high relative to the impedance of the Trapatt diode. The oscillator includes a low-pass filter comprising four so-called stubs or coaxial sleeves which are spaced along the line between the inner and outer conductors and which each give the line a locally reduced impedance, each providing two step transitions in impedance respectively from a high to a low impedance and from a low to a high impedance. The positions of the stubs are adjustable. The high-to-low step transition in impedance (as seen from the diode) provided by the stub nearest the diode constitutes the trigger element of the oscillator. The portion of the line immediately adjacent the diode is also of a low impedance, providing a so-called step transformer, there being a single step transition from this low impedance to the higher impedance of the majority of the line. According to the U.S. patent, this step transformer has three functions: its primary function is to match the low impedance of the diode to the high impedance of the line and the output line connected thereto, and its other functions are said to be to control the optimum delay angle $\theta_d$ for Trapatt diode operation (dependent on various characteristics of the diode) and to provide a large capacitance near the diode. The patent also states that for high efficiency operation, the total impedance seen by the diode must haver certain properties which cannot be provided by the step transformer alone; for this reason, the low-pass filter must be utilised.

The Applicants have found that the operation of such a Trapatt oscillator is critically dependent on the precise setting of the positions of the filter stubs: a lengthy iterative process of adjusting the filter is required to obtain a satisfactory compromise between waveform, power, efficiency and frequency. The effects of a particular setting may not be reproducible even on a single oscillator, let alone from one oscillator to another, and the filter must be readjusted if for example the diode is changed. Furthermore, it has been found that for any particular filter setting, the diode can usually be driven over only part of its operable current range. It has also been found that without such a low-pass filter, the oscillator will indeed operate, but only at substantially one frequency and at not very good efficiency.

These difficulties are considered to be responsible for preventing Trapatt oscillators from being practicable for mass-production.

The reasons for these difficulties with conventional Trapatt oscillators are thought to be as follows.

The oscillator relies for its operation upon repeated triggering of the diode by pulses reflected from the high-to-low impedance transition (as seen from the diode) at the filter stub nearest the diode. Since each transition from a high impedance to a low impedance (as seen from the Trapatt diode), in particular such transitions in the filter which forms part of the oscillator, is capable of generating a trigger voltage from a single diode-stimulus, spurious or multiple triggering is possible. Since each of these multiple trigger pulses can compete to control the oscillation frequency, coherent oscillation requires one trigger to achieve dominance.

Little, if any, serious investigation appears to have been carried out on the practical problem of preventing the diode voltage from exceeding avalanche breakdown between trigger pulses, particularly during the transient phase of the Trapatt mode, that is to say during the time period between the first Trapatt pulse and the cycle in which coherence is established. Increased lumped local capacitance and a trigger-line with a single impedance step (as in the oscillator of the above-mentioned U.S. Patent) have been found from experience to be advantageous, but it is likely that such voltage supression has, in the main, been inadvertently achieved by reflections from discontinuities between a low impedance and a high impedance from components between the Trapatt diode and the radio-frequency load.

Hitherto it has been thought that Trapatt oscillator circuits merely provided the necessary steady state impedances at the fundamental and harmonically related frequencies (the low-pass filter being required in particular for these harmonics), but in practice it is thought that they also provided the voltage-steps for suppressing the diode voltage between trigger pulses. Thus, to achieve coherence to accommodate this unanticipated role, the many elements of the oscillator circuit almost always require empirical adjustment. Failure to prevent the diode voltage exceeding avalanche breakdown between triggers will lead to different diode states prior to each trigger pulse and hence preclude coherence.

The object of this invention is two fold: first to inhibit unwanted triggering by reflections from discontinuities and thus to increase the effectiveness of the trigger reflection from the trigger element, and secondly to suppress the diode voltage during the recovery period.

According to the invention, a time-delay-triggered Trapatt oscillator as set forth in the opening paragraph is characterised in that said further transitions are each from a lower to a higher impedance

# 0 022 601

as seen from the diode and are located between the diode and the trigger element so that the impedance of the transmission line progressively increases along the line from the diode to the trigger element.

The "further transitions in impedance" are to be understood to include tapering of the line, which can be considered as a large number of successive very small impedance steps.

The further transitions may be step transitions, so that the transmission line comprises a plurality of sections the respective impedances of which progressively increase from the diode. Alternatively, the further transitions may form a taper, so that there is a continuous increase in impedance along the line from the diode. Alternatively, the further transitions may partly be step transitions and partly form a taper.

When the oscillator is in coaxial line, the stepping and/or tapering may be applied to the inner conductor or the outer conductor or both.

Suitably, the oscillator is combined with a directional filter for deriving energy at the desired frequency while providing a broad-band match to the oscillator, the directional filter being connected to the transmission line beyond the trigger element, as seen from the diode.

An oscillator embodying the invention does not require the use of a low-pass filter such as employed in conventional Trapatt oscillators, and can readily be set up to operate with a desired fundamental frequency and with good efficiency. The operation of the oscillator is much less dependent on the positions of the further transitions than prior-art oscillators. In marked contrast to the latter, the performance deteriorates only gradually as the transitions are moved from their optimum positions, and the transitions can be moved quite some distance before the oscillator will not produce coherent oscillations. Furthermore, replacement of the diode by a significantly different one has been found to necessitate little or no adjustment of the positions of the transitions. In addition, the fundamental frequency can be varied over a useful bandwidth by adjusting the position of the trigger element, while the efficiency is generally at least as good as that of prior-art oscillators.

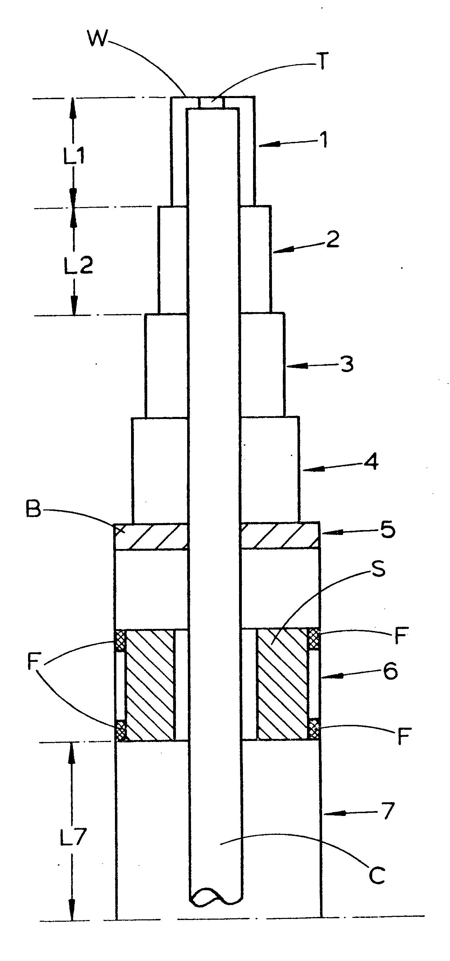

Embodiments of the invention will now be described by way of example with reference to the single figure of the diagrammatic drawing which illustrates a coaxial form of Trapatt oscillator.

Referring to the Figure, which is not drawn to scale, a Trapatt oscillator arrangement comprises a centre conductor C of constant diameter and an outer conductor, of which the Figure shows diagrammatically only the outline of the inner surface, which is of stepped formation and can conveniently be regarded as being formed of sections 1, 2 ... 7 respectively of lengths L1, L2 ... L7 having respective characteristic impedances, not indicated on the Figure, Z1, Z2 ... Z7.

At the upper end as viewed in the Figure this coaxial system is terminated by a transverse wall W between which and the end of the central conductor C is a Trapatt diode T.

The delay line, the length of which primarily determines the frequency of oscillation, and from the end of which remote from the diode T are reflected the pulses which act as trigger pulses, is formed of the sections 1 to 5 inclusive, whilst the step transition from high to low impedance at the junction of sections 5 and 6 forms a trigger element which reflects part of the pulse from the diode T back along the line to trigger the next pulse.

Beyond the section 6 is a further section 7 which forms the output section of the oscillator arrangement and to which the load and the bias circuits for the diode would be coupled in the usual way. The length of this section is, of course, immaterial provided that the termination is a broad-band match that is to say a constant resistance network for example such as that disclosed in published U.K. Patent Application 2,026,800A.

It will be appreciated that because the high-to-low impedance transition between sections 5 and 6 is the only one of its kind, then this is the only one in the oscillator arrangement which would invert the negative-going pulse from the diode so that a positive-going trigger pulse is returned down the delay line to the diode. Because all the other impedance transitions are low-to-high, reflections of the diode pulse are not inverted but are returned as a series of negative-going pulses which act to inhibit or suppress the rise in the diode voltage between trigger pulses and thus to stabilize the effect of the trigger pulses reflected at the trigger element formed by the impedance transition 5—6.

Section 5 of the arrangement carries a polystyrene washer B some 3 mm long which is a good fit in the outer conductor and over the inner conductor C: the reason for providing this washer is purely mechanical, to add strength to the assembly.

Section 6 of the arrangement was in the form of a brass slug S of annular cross section slidable within the continuous inner surface of sections 5 and 7 and having spring contact fingers F which engage this surface: this enabled the length of section 5, and hence the fundamental frequency of oscillation to be varied. It was found that by the use of this construction the fundamental frequency could be varied between the approximate limits of 1.8 to 2.5 GHz whilst at the same time maintaining coherence.

Examples and dimensions of some embodiments in coaxial line will now be given with reference to the Figure. In all examples the centre conductor C was 3 mm in dimaeter: in the following examples $d$ is the inner diameter of the outer conductor. The frequency was 2.5 GHz in all cases and operation was pulsed with a duty cycle of 0.1%.

3

**0 022 601**

Example 1

| Section | Z (ohms) | L (mm) | $d$ (mm) |
|---------|----------|--------|----------|
| 1 | 10 | 15 | 3.5 |
| 2 | 15 | 9 | 4 |
| 3 | 20 | 9 | 4.2 |
| 4 | 30 | 9 | 5.0 |
| 5 | 50 | 8 | 7 |
| 6 | 10 | 13.5 | 3.5 |
| 7 | 50 | | 7 |

In this Example the mean current drawn by the diode during the pulse could be varied from about 2 amps to at least 4 amps and at the latter current a peak output power of 40 watts was reached.

Example 2

Dimensions were as for Example 1 except that section 6 was 9 mm long. The output power was some 45 watts with an input pulse current of 4 amps.

Example 3

Dimensions were as for Example 2 except that L2 was 9 mm and Z2 was 20 ohms so that in effect this was a four-section line instead of a five-section line as in the Figure, since sections 2 and 3 of the Figure were identical. This arrangement could only be driven up to 3.7 amps mean current during the pulse but output powers of up to 50 watts were attained.

Example 4

| Section | Z (ohms) | L (mm) |
|---------|----------|--------|
| 1 | 10 | 6 |
| 2 | 15 | 18 |
| 3 | 20 | 9 |
| 4 | 30 | 9 |
| 5 | 50 | 9 |
| 6 | 10 | 9 |
| 7 | 50 | |

Output powers of some 60 watts were attained with this arrangement, again with an input pulse current of 4 amps.

Example 5

Dimensions were the same as for Example 4 except that Section 1 was 9 mm long and was loaded with a cross-linked polystyrene slug some 2 mm long, and peak outputs of over 60 watts were attained.

Example 6

A fixed-frequency oscillator at 2.5 GHz was made to the same dimensions as those of Example 2 with the difference that the brass slug S forming the low-impedance section L6 was omitted and instead the centre conductor C was formed with a portion 9 mm long and having an increased diameter of 6 mm.

Although the embodiments described above are all in coaxial line configuration it will of course be understood that the techniques discussed in this specification are equally applicable to other forms of transmission line such as for example stripline.

**Claims**

1. A time-delay-triggered Trapatt oscillator comprising a Trapatt diode and a transmission line connected across the diode, wherein the transmission line comprises a trigger element in the form of a step transition from a high to a low impedance as seen from the diode, the transition being spaced from the diode to reflect energy produced by the diode back thereto so as to trigger the further production of energy by the diode, and wherein the transmission line comprises further transitions in impedance spaced along the line, characterized in that said further transitions are each from a lower to a higher impedance as seen from the diode and are located between the diode and the trigger element so that the impedance of the transmission line progressively increases along the line from the diode to the trigger element.

2. An oscillator as claimed in Claim 1, characterized in that the further transitions are step transitions.

3. An oscillator as claimed in Claim 1, characterized in that the further transitions form a taper.

4

4. An oscillator as claimed in Claim 1, characterized in that the further transitions partly are step transitions and partly form a taper.

5. An oscillator as claimed in any preceding claim in combination with a directional filter for deriving energy at the desired frequency while providing a broad-band match to the oscillator, the direction filter being connected to the transmission line beyond the trigger element, as seen from the diode.

**Patentansprüche**

1. Mit Hilfe der Laufzeit gestarteter Trapatt-Oszillator mit einer Trapatt-Diode und einer Übertragungsleitung, die über die Diode angeschlossen ist, wobei die Übertragungsleitung ein Triggerelement aufweist in Form eines Schrittüberganges von einer, aus der Sicht der Diode, hohen zu einer niedrigen Impedanz, wobei der Übergang mit einem Zwischenraum von der Diode angeordnet ist um Energie, die von der Diode geliefert wird, zu der Diode zurückzuwerfen um eine weitere Energieerzeugung durch die Diode in Gang zu setzen und wobei die Übertragungsleitung weitere Impedanzübergänge aufweist, die mit Zwischenräumen längs der Leitung angeordnet sind, dadurch gekennzeichnet, dass die genannten weiteren Übergänge, aus der Sicht der Diode, je von einer niedrigeren zu einer höheren Impedanz gehen und dass sie zwischen der Diode und dem Triggerelement derart angeordnet sind, dass die Impedanz der Übertragungsleitung längs der Leitung von der Diode zu dem Triggerelement allmählich zunimmt.

2. Oszillator nach Anspruch 1, dadurch gekennzeichnet, dass die weiteren Übergänge Schrittübergänge sind.

3. Oszillator nach Anspruch 1, dadurch gekennzeichnet, dass die weiteren Übergänge eine Verengung bilden.

4. Oszillator nach Anspruch 1, dadurch gekennzeichnet, dass die weiteren Übergänge teilweise Schrittübergänge sind und teilweise eine Verengung bilden.

5. Oszillator nach einem der vorstehenden Ansprüche, kombiniert mit einem Richtfilter zum Ableiten von Energie auf der gewünschten Frequenz, wobei an dem Oszillator eine Breitbandanpassung geschaffen wird, wobei das Richtfilter, aus der Sicht der Diode, hinter dem Triggerelement mit der Übertragungsleitung verbunden ist.

**Revendications**

1. Oscillateur Trapatt déclenché avec retard comprenant une diode Trapatt et une ligne de transmission connectée à la diode, dans lequel la ligne de transmission comprend un élément de déclenchement ayant la forme d'une transition en échelon d'une haute impédance vers une basse impédance, vu à partir de la diode, la transition étant espacée de la diode pour réfléchir l'énergie produite par la diode vers celle-ci de manière à déclencher toute production ultérieure d'énergie par la diode, d'autres transitions d'impédance étant espacées le long de la ligne de transmission, caractérisé en ce que les autres transitions vont chacune d'une basse impédance à une haute impédance, vu à partir de la diode, et sont placées entre la diode et l'élément de déclenchement de sorte que l'impédance de la ligne de transmission augmente progressivement le long de la ligne à partir de la diode vers l'élément de déclenchement.

2. Oscillateur suivant la revendication 1, caractérisé en ce que les autres transitions sont des transitions en échelons.

3. Oscillateur suivant la revendication 1, caractérisé en ce que les autres transitions forment un changement continu.

4. Oscillateur suivant la revendication 1, caractérisé en ce que les autres transitions sont, pour partie, des transitions en échelons et, pour partie, des transitions formant un changement continu.

5. Oscillateur suivant l'une quelconque des revendications 1 à 4, en combinaison avec un filtre directionnel pour dériver de l'énergie à la fréquence souhaitée tout en fournissant une adaptation à large bande à l'oscillateur, le filtre directionnel étant connecté` la ligne de transmission au-delà de l'élément de déclenchement, vu à partir de la diode.